# EUROPEAN PATENT APPLICATION

(11) **EP 2 270 627 A1**
(43) Date of publication of application: **05.01.2011**
(21) Application number: 09164152.2
(22) Date of filing: 30.06.2009
(51) Int. Cl.: G06F 3/01

(54) **Method and apparatus for providing tactile feedback**

(71) Applicant: RESEARCH IN MOTION LIMITED, Waterloo, Ontario N2L 3W8 (CA)
(72) Inventor: Weber, Arnett, Waterloo Ontario N2L 3W8 (CA); Faubert, Perry, Waterloo Ontario N2L 3W8 (CA); Robinson, James Alexander, Waterloo Ontario N2L 3W8 (CA)
(74) Representative: Fennell, Gareth Charles

(57) **Abstract**

Methods and apparatus for providing tactile feedback to a touch-sensitive display comprising detecting a touch on the touch-sensitive display and providing tactile feedback by one or more actuators in response to the touch, wherein tactile feedback is substantially the same regardless of a location of the touch. Tactile feedback may optionally be based on the location of the touch relative to the location of the actuators and may also optionally be based on the force of the touch.

## Description

### FIELD OF TECHNOLOGY

The present disclosure relates to touch-sensitive displays, including, but not limited to, portable electronic devices having touch-sensitive displays and their control.

### BACKGROUND

Electronic devices, including portable electronic devices, have gained widespread use and may provide a variety of functions including, for example, telephonic, electronic messaging and other personal information manager (PIM) application functions. Portable electronic devices include, for example, several types of mobile stations such as simple cellular telephones, smart telephones, wireless personal digital assistants (PDAs), and laptop computers with wireless 702.11 or Bluetooth capabilities. These devices run on a wide variety of networks from data-only networks such as Mobitex® and DataTAC® networks to complex voice and data networks such as GSM/GPRS, CDMA, EDGE, UMTS and CDM52000 networks.

Portable electronic devices such as PDAs or smart telephones are generally intended for handheld use and ease of portability. Smaller devices are generally desirable for portability. A touch screen display for input and output is particularly useful on such handheld devices, as such handheld devices are small and are therefore limited in space available for user input and output devices. Further, the screen content on the touch screen display devices may be modified depending on the functions and operations being performed. Even still, these devices have a limited area for rendering content on the touch screen display and for rendering features or icons, for example, for user interaction. With continued demand for decreased size of portable electronic devices, touch screen displays continue to decrease in size.

Improvements in touch screen devices are therefore desirable.

### BRIEF DESCRIPTION OF THE DRAWINGS

FIG. 1 is a block diagram of a portable electronic device in accordance with the present disclosure.

FIG. 2, FIG. 3, and FIG. 4 illustrate touch-sensitive displays that provide tactile feedback in accordance with the present disclosure.

FIG. 5 illustrates a flowchart of a method of activating actuator(s) for a touch-sensitive display in accordance with the present disclosure.

FIG. 6, FIG. 8, FIG. 9, and FIG. 7 illustrate touches on different locations of a touch-sensitive display that provides tactile feedback in accordance with the present disclosure.

### DETAILED DESCRIPTION

For simplicity and clarity of illustration, reference numerals may be repeated among the figures to indicate corresponding or analogous elements. In addition, numerous specific details are set forth in order to provide a thorough understanding of the embodiments described herein. The embodiments described herein may be practiced without these specific details. In other instances, well-known methods, procedures and components have not been described in detail so as not to obscure the embodiments described herein. Also, the description is not to be considered as limited to the scope or the embodiments described herein.

The disclosure generally relates to an electronic device, which in the embodiments described herein is a portable electronic device. Examples of portable electronic devices include mobile, or handheld, wireless communication devices such as pagers, cellular phones, cellular smartphones, wireless organizers, personal digital assistants, wirelessly enabled notebook computers, and the like. The portable electronic device may also be a portable electronic device without wireless communication capabilities such as a handheld electronic game device, digital photograph album, digital camera, or other device.

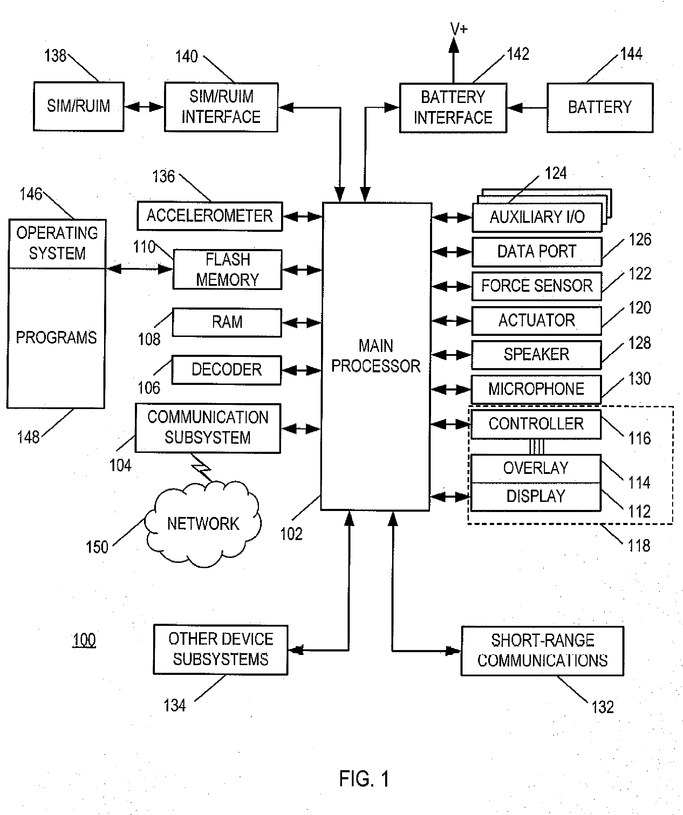

A block diagram of an example of an embodiment of a portable electronic device 100 is shown in FIG. 1. The portable electronic device 100 includes a number of components such as a processor 102 that controls the overall operation of the portable electronic device 100. Communication functions, including data and voice communications, are performed through a communication subsystem 104. Data received by the portable electronic device 100 is decompressed and decrypted by a decoder 106. The communication subsystem 104 receives messages from and sends messages to a wireless network 150. The wireless network 150 may be any type of wireless network, including, but not limited to, data-centric wireless networks, voice-centric wireless networks, and dual-mode networks that support both voice and data communications over the same physical base stations. The portable electronic device 100 is a battery-powered device and includes a battery interface 142 for receiving one or more rechargeable batteries 144.

The processor 102 also interacts with additional subsystems such as a Random Access Memory (RAM) 108, a flash memory 110, a display 112 with a touch-sensitive overlay 114 connected to an electronic controller 116 that together make up a touch-sensitive display 118, an actuator 120, a force senor 122, an auxiliary input/output (I/O) subsystem 124, a data port 126, a speaker 128, a microphone 130, short-range communications 132 and other device subsystems 134. The processor 102 interacts with the touch-sensitive overlay 118 via the electronic controller 116. The processor 102 may also interact with an accelerometer 136 as shown in FIG. 1. The accelerometer 136 may include a cantilever beam with a proof mass and suitable deflection sensing circuitry. The accelerometer 136 may be utilized for detecting direction of gravitational forces or gravity-induced reaction forces.

To identify a subscriber for network access according to the present embodiment, the portable electronic device 100 uses a Subscriber Identity Module or a Removable User Identity Module (SIM/RUIM) card 138 inserted into a SIM/RUIM interface 140 for communication with a network such as the wireless network 150. Alternatively, user identification information may be programmed into the flash memory 110.

The portable electronic device 100 also includes an operating system 146 and software components 148 that are executed by the processor 102 and are typically stored in a persistent store such as the flash memory 110. Additional applications may be loaded onto the portable electronic device 100 through the wireless network 150, the auxiliary I/O subsystem 124, the data port 126, the short-range communications subsystem 132, or any other suitable device subsystem 134.

In use, a received signal such as a text message, an e-mail message, or web page download is processed by the communication subsystem 104 and input to the processor 102. The processor 102 then processes the received signal for output to the display 112 or alternatively to the auxiliary I/O subsystem 124. A subscriber may also compose data items, such as e-mail messages, for example, which may be transmitted over the wireless network 150 through the communication subsystem 104. For voice communications, the overall operation of the portable electronic device 100 is substantially similar except that the received signals are output to the speaker 128 and signals for transmission are generated by the microphone 130.

Touch-sensitive displays that provide tactile feedback are known. Stiffness of and friction between different components within the portable electronic device may affect the consistency of tactile feedback at different locations on the touch-sensitive display. Proximity to the device(s) providing tactile feedback may also affect the consistency of tactile feedback. As a result, more intense feedback may be provided to some locations on the display, which may be referred to as "hot" locations, while less intense feedback may be provided to other locations on the display, which may be referred to as "weak" locations. For example, the tactile feedback provided at a corner of the display of the portable electronic device may be stronger or more intense, particularly when the device(s) generating tactile feedback is (are) disposed near the corner. The tactile feedback provided near the center of the display or along an edge of the display and away from its corners may be weaker or less intense, particularly when the device(s) generating tactile feedback is (are) disposed near the corner(s). In an example portable electronic device where a single device generates tactile feedback from the center of the display, the strength or intensity of the feedback may progressively dissipate the further from the center of the display the touch is. Similarly, open volumes, various components, or arrangements/assembiies of components may affect feedback at various locations. For example, one or more adhesive layers applied around the perimeter or covering the entire display of the touch screen may affect the bending or stiffness of the display; spring elements that suspend the display module, e.g., foam or metal springs, may affect the movement of the display; and flexible printed circuit connections to the display module may restrict the movement of the display at a location around a perimeter of the display.

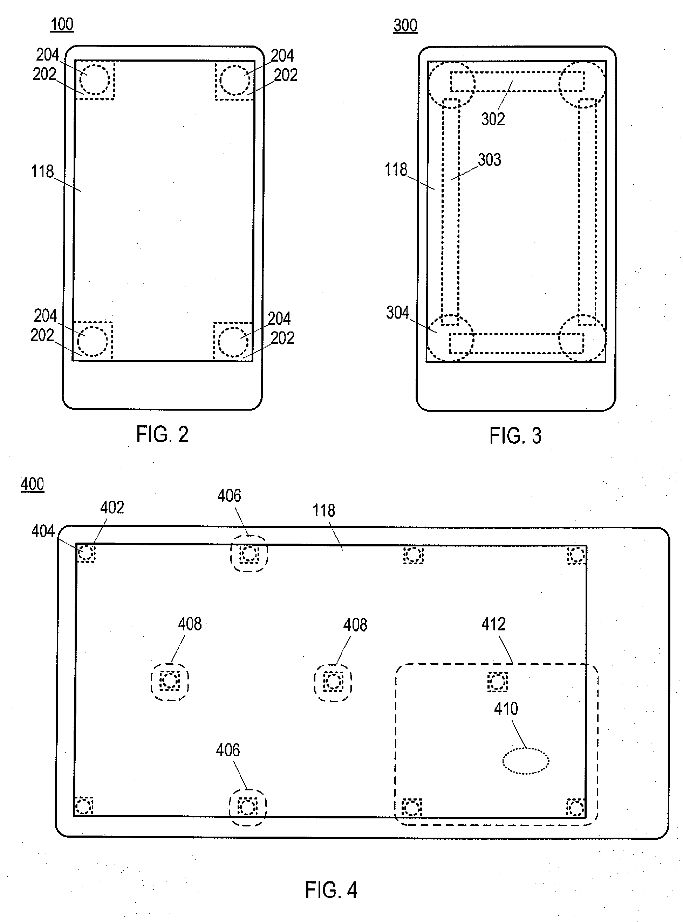

A touch-sensitive display that provides tactile feedback is illustrated in FIG. 2. The portable electronic device 100 comprises a touch-sensitive display 118, one or more force sensors 202, and one or more actuators 204. When the touch-sensitive display 118 is touched with sufficient force (as detected by the force sensors 202), tactile feedback is provided to the display 118, which is substantially the same regardless of a location of the touch.

The touch-sensitive display 118 may advantageously provide data related to the location of a touch on the touch-sensitive display 118. For example, the touch-sensitive display 118 may provide a set (or tuple) of location information that comprises horizontal location information, vertical location information, and size information that are related to a touch on the touch-sensitive display 118. Alternatively, the touch-sensitive display 118 may provide information directly from one or more sensors from which horizontal, vertical, and/or size information for a touch may be determined.

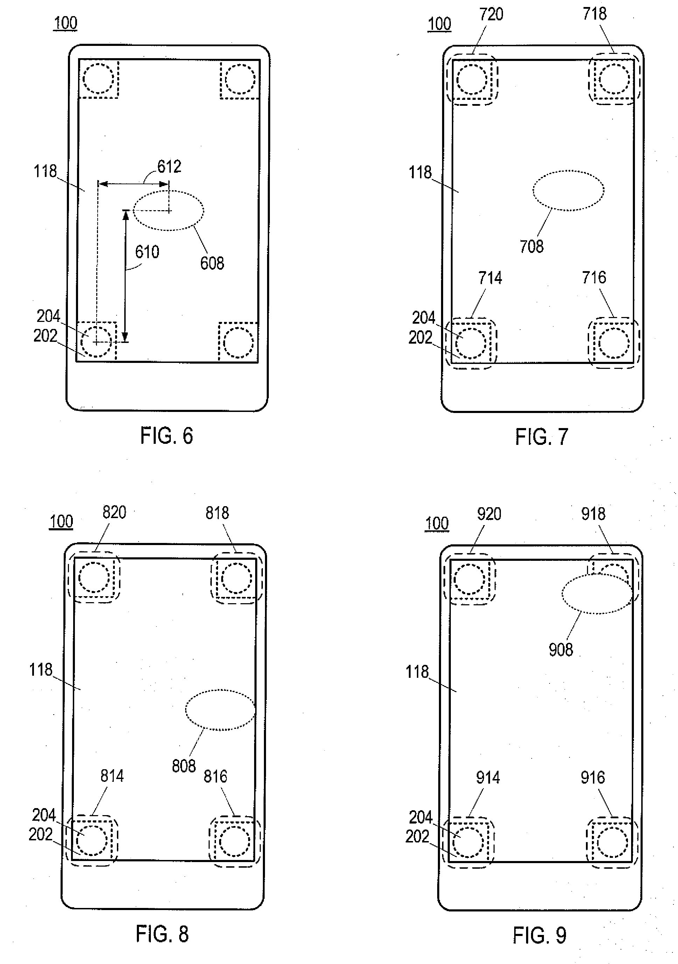

Horizontal and vertical location information may indicate horizontal and vertical distances based on a reference point that is located at the bottom-left of the touch-sensitive display 118, the center of the touch-sensitive display 118, or any other point on touch-sensitive display 118. For example, when the reference point is at a center of the display and a location of a touch is also at the center of a display (e.g., the cross at the center of the location 608 of the touch of FIG. 6), the display 118 may provide horizontal and vertical information with values of zero (e.g., the set (0,0)) that indicate the touch is located at the center of display.

Size information may indicate how much of the touch-sensitive display 118 is detected as being touched. For instance, when the display 118 is touched with a tip of a finger compared to when the display 118 is touched with a palm of a hand, the size information comprises a smaller value when the finger touches the display 118 than when the palm touches the display 118.

A force sensor 202 is shown located beneath the touch-sensitive display 118 in/near each corner. The force sensors 202 provide force information related to and indicative of the force imparted by touches on the touch-sensitive display 118. Each force sensor 202 may provide its own force information, or information from more than one force sensor 202 may be combined. For example, the force information provided may be from one or more force sensors that are closest to a touch location. The force information provided may be force information that exceeds a threshold value from one or more force sensors 202. Force sensors 202 may alternatively be grouped based on the location of the individual force sensors relative to a touch. For example, a group 412 of sensors and actuators that may be based on the location of the touch 410 is depicted in FIG. 4.

The actuators 204 are also shown located in/near the corners of the touch-sensitive display 118 and may be beneath the force sensors 202. The actuators 204 may be separately controlled. Additionally or alternatively, each actuator 204 may be grouped to facilitate collective control of the actuators 204. The actuators 204 may be piezoelectric actuators or any other suitable actuation device, such as piezoelectric vibrator, magnetic vibrator, or a magnetic actuator.

An alternative embodiment of a touch-sensitive display that provides tactile feedback is illustrated in FIG. 3. The portable electronic device 300 includes one or more elongated force sensors 302, 303 that are disposed near the edges of the touch-sensitive display 118. The actuators 304 are depicted as larger than those of FIG. 2. Any suitably sized actuator that provides tactile feedback may be utilized.

Another alternative embodiment of a touch-sensitive display that provides tactile feedback is illustrated in FIG. 4. A portable electronic device 400 is shown in a landscape orientation. In addition to the force sensors 402 and actuators 404 in/near the corners of the touch-sensitive display 118, the device 400 also contains force sensors 402 and actuators 404 disposed in locations 406 along edges of the display 118 and in locations 408 away from the edges of the display 118. Tactile feedback provided by the portable electronic device 400 may be based on force information from one or more force sensors 402 closest to a touch, and tactile feedback may be provided by one or more actuators 404 closest to a touch. For example, when a touch 410 is detected in the lower right corner 412 of the touch-sensitive display 118, tactile feedback may be based on force information from the force sensors 402 and supplied by the actuators 404 in the lower right corner 412.

FIG. 2, FIG. 3, and FIG. 4 depict portable electronic devices 100, 300, 400 that include touch-sensitive displays 118 that provide location information and force characteristics of touches. Providing both location and force information is not required to successfully achieve advantages as set forth in this disclosure. For example, an embodiment may provide location information, although force sensors need not be implemented. Force data may be provided in another embodiment, e.g., via force sensors, although location information need not be provided.

Any quantity, arrangement, or size of force sensors 202, 302, 303, 402 may be utilized to provide force characteristic information for a touch for any embodiment of a touch-sensitive display 118. Any quantity, arrangement, or size of one or more actuators 204, 304, 404 may be utilized to supply tactile feedback for any embodiment of a touch-sensitive display 118. The force sensors 202, 302, 303, 402 may advantageously be colocated with the actuators 204, 304, 404, or the force sensors 202, 302, 402 may be located in different places than the actuators 204, 304, 404.

Although FIG. 2, FIG. 3, and FIG. 4 depict portable electronic devices 100, 300, 400, similar configurations of force sensors and actuators may be used with other devices. For example, the teachings of the disclosure may be applied to automated teller machines and point-of-sale terminals. The teachings of the disclosure may be applied to other devices that are or are not portable.

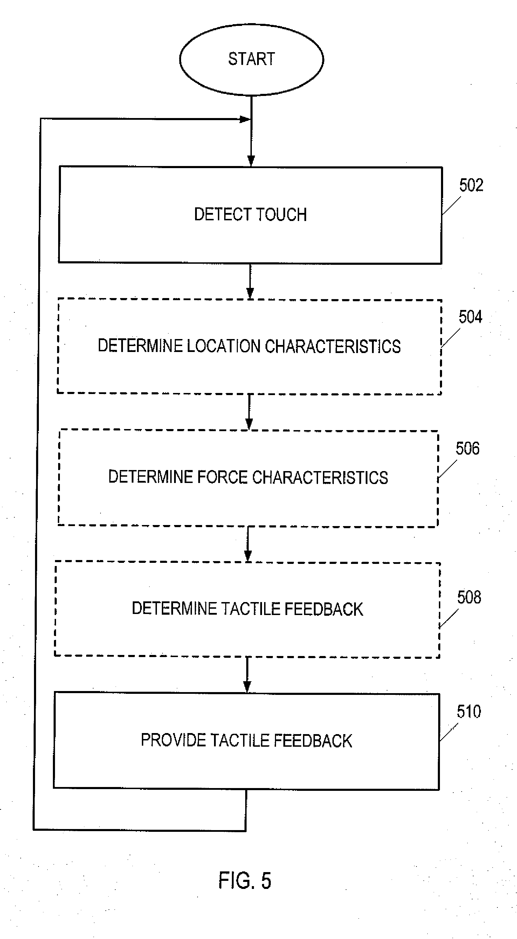

A method for providing tactile feedback is illustrated in the flowchart of FIG. 5. The method of FIG. 5 may be performed by software executed by, for example, the processor 102. Given the present disclosure, one of skill in the art is capable of coding of software for carrying out the method. The method will be described with respect to the portable electronic device 100 of FIG. 1 and FIG. 2, although the flowchart may apply to any of the portable electronic devices 300, 400 described herein, or other portable electronic devices not described herein. A touch on a display, such as the touch-sensitive display 118, is detected by a device, such as portable handheld device 100, at step 502. The touch may be from one or more fingers, a stylus, or any other apparatus detectable by the device. The touch may be detected through the use of any number or combination of sensors, including a touch-sensitive overlay 114 and/or one or more force sensors 202. Additionally or alternatively, a touch may be detected when a predetermined amount of force is imparted by the touch. In other words, a threshold related to the force may be used such that touches having a force below the threshold are not detected and touches having a force above the threshold are detected. This threshold may, for example distinguish between intentional touches and unintentional touches or between touches that select and touches that highlight.

The processor 102 may receive one or more touch signals from the touch sensitive display 118 and/or the force sensors 202 that indicate any combination of a touch on the display 118, a location of the touch, or a force of the touch. The touch signals may comprise any combination of information directly from one or more sensors; information that is combined from multiple sensors 202; or information that has been analyzed before receipt by the processor 102. For example, the processor 102 may receive a signal from a single force sensor 202, or it may receive force information from multiple force sensors 202, such as the group of force sensors 402 within the lower right corner 412 of FIG. 4. Alternatively, the processor 102 may receive signals comprising information previously analyzed by the controller 116.

Location characteristics of the touch are optionally determined at step 504. Location characteristics of a touch may include a horizontal location, a vertical location, and/or a size of the touch. Additionally, location characteristics may be analyzed to determine relationships between the location of a touch and any of the force sensors 2 or any of the actuators 204 of the device.

Force characteristics of the touch are optionally determined at step 506. Force information indicating the force characteristics of the touch may be obtained from one or more force sensors, and force information from multiple sensors 202 may be combined. For example, force information from the four force sensors 202 of the portable electronic device 100 of FIG. 2 may be combined to provide an indication of an overall force of a touch on display 118, Additionally, force characteristics may be analyzed to determine relationships between a force of a touch and any of the actuators 204 of the device, such as the relation of the force of the touch to the position of each of the actuators 204.

Tactile feedback is optionally determined at step 508. The portable electronic device 100 may determine whether or not to provide any tactile feedback, what type of tactile feedback to provide, and/or what amount or level of tactile feedback to provide. Additionally, this determination may be based on location and/or force characteristics of a touch.

When determining whether or not to provide tactile feedback based on force characteristics, values of the force characteristics relative to one or more thresholds may be used to determine whether tactile feedback is provided. For example, a minimum and a maximum threshold may be utilized such that tactile feedback is provided when the force of a touch is at or between the values of the minimum threshold and the maximum threshold. As such, the device may not provide any tactile feedback when various characteristics of the touch do not meet various thresholds. Furthermore, different applications running on the device may have unique threshold requirements or the applications may set or alter the thresholds of the device

When determining whether or not to provide tactile feedback based on location characteristics, a map or table may be utilized to determine whether tactile feedback is provided. For example, the values of the location characteristics of a touch may be utilized to look up a value in the map or table that determines whether to provide tactile feedback. An application may determine or alter the values in the map or table.

Applications stored on the portable electronic device 100 may have a setting that disables some or all tactile feedback.

The type of tactile feedback provided by the device may include any one or combination of a pulse (such as force applied to the touch-sensitive display 118), a continuous buzz (or vibration), periodic pulses, periodic buzzes, or the like. The type of tactile feedback may be based on location or force characteristics or on an application running on the device. When determining the type of tactile feedback, any number or combination of thresholds, maps, tables, or settings (as discussed above) may be utilized. Different types of tactile feedback may be provided by different combinations of actuators 204. For example, a periodic pulse may be provided by an actuator and a continuous buzz may be provided by a one or more actuators.

The amount or level of tactile feedback provided by the device may be based on location or force characteristics or on an application running on the device 100. When determining the amount of tactile feedback, any number or combination of thresholds, maps, tables, or settings (as discussed above) may be utilized. Different amounts of tactile feedback may be provided by different combinations of actuators. For example, a large amount of tactile feedback may be provided by an actuator closest to a touch and a small amount of tactile feedback may be provided by one or more actuators that are farthest from the touch. The same activation signal may be sent to two or more actuators. For example, the same intensity, strength, or amplitude of tactile feedback may be provided by each actuator, although the intensity, strength, or amplitude may be modified based on the location of the touch. For example, reduced intensity, strength, or amplitude of tactile feedback may be provided to known "hot" locations compared to average locations, and increased intensity, strength, or amplitude of tactile feedback may be provided to known "weak" locations compared to average locations. "Hot" and "wreak" locations may be identified through measurement or other known methods. A table, model, or equation may be utilized to identify all locations and the corresponding feedback adjustment or magnitude to result in the same effective intensity, strength, or amplitude of feedback at each location.

Tactile feedback is provided at step 510. For example, the actuators 204 of the portable electronic device 100 of FIG. 2 may provide tactile feedback when the actuators 204 are provided with an activation signal. The activation signal provided to an actuator 204 may control the type and amount of tactile feedback that the actuator 204 provides. The activation signal may comprise an activation level that indicates the amount or intensity of tactile feedback. The activation signal may also indicate the type of tactile feedback, e.g., pulse, buzz, and so forth as discussed above. Each actuator may receive different activation signals having different activation levels or indicating different types of tactile feedback based on the same touch detected by the device.

Additionally, embodiments incorporating the teachings of the disclosure may comprise one or more computer readable media that cause one or more processors to perform the teachings of the disclosure. Such computer-readable media may include, but are not limited to, CDs, DVDs, read-only memory, random-access memory, memory caches, and the like.

A touch location 608 is shown at the center of the display 118 in FIG. 6. A vertical distance 610 and a horizontal distance 612 are shown between the touch location 608 and the actuator 204 may be determined as known in the art. Additionally or alternatively, the distance between touch location 608 and force sensor 204 may also be determined. These distances 610, 612 may be advantageously established from a vertical or horizontal center of the touch location 608 and a vertical or horizontal center of the actuator 204. The distances 610 and 612 may be utilized to determine an amount of tactile feedback to be provided by the bottom-left actuator 204. Alternatively, the magnitude of the distance between a touch location and an actuator 204 may be utilized instead of separate vertical and horizontal components. Although the center of a touch is utilized for measurement, different points of a touch may be utilized. Similarly, distances between all other force sensors 202 and actuators 204 may be determined and utilized to determine tactile feedback to be provided by respective actuators.

The center of the touch location 608 is at the center of the display 118 and the four actuators 204 depicted in FIG. 6 are in the corners of the display such that the horizontal and vertical distances between the touch location 608 and each of the four actuators 204 are the same. At the center touch location 608, the contribution to tactile feedback that is provided by each of the actuators 204 is the same when the same activation signal/level is provided to each of the actuators 204. In other words, the contribution to tactile feedback from each of the actuators 204 is the same when a touch is at the center location 608.

An off-center touch location 708 is shown away from the corners, edges, and center point of the display 118 in FIG. 7. This touch location 708 is closer to the actuator 204 at the upper-right position 718 than to the actuators 204 at the lower-left position 714, the lower-right position 716, and the upper-left position 720. When the same level of tactile feedback is provided by each actuator 204, the actuator 204 at the upper-right location 718 contributes more to the tactile feedback at the off-center location 708 than is provided by the actuators 204 at the other locations 714, 716, 720. In order to provide the same tactile feedback for a touch at the off-center location 708 as for a touch at another location such as the center location 608, the activation levels in the activation signals sent to the actuators 204 are established based on the location of the touch and result in appropriately different activation levels at the various actuators 204.

An edge touch location 808 is shown in the middle of an edge of the display 118 in FIG. 8. The edge touch location 808 is closer to the actuators 204 in the right-side positions 816, 818 than to the actuators 204 in the left-side positions 814, 820. When the same level of tactile feedback is provided by each actuator 204, at the edge location 808, the contribution to tactile feedback that is provided by the actuators 204 in the right-side positions 816, 818 is greater than the tactile feedback that is provided by the actuators 204 in the left-side positions 814, 820. In order to provide the same tactile feedback for a touch at the edge location 808, as for other locations such as the center location 608 or off-center-location 708, the activation levels in the activation signals sent to the actuators 204 are established based on the location of the touch and result in appropriately different activation levels at the various actuators 204.

For example, the tactile feedback may be measured at the center location 608 and the edge location 808 with a tactile feedback sensor (not shown). The activation levels for the activation signals for the actuators 204 are appropriately adjusted such that the tactile feedback measured at the center location 608 and the edge location 808 are substantially the same. These adjustments to the activation signals may be stored in a map or table (as described above) or may be obtained through an equation that relates a touch location to a location of an actuator. Alternatively, actual activation levels may be utilized instead of adjustments to activation levels.

Optionally, for an edge touch location, one at or near an edge of the display 118, the two closest actuators 204 may be the only actuators that provide tactile feedback. For example, the actuators 204 in the right-side positions 816, 818 provide tactile feedback, but the actuators 204 in the left-side positions 814, 820 do not provide tactile feedback for the edge location touch 808 in FIG. 8. The activation level(s) in the activation signals to each of the two actuators 204 in the right-side positions 816, 818 for the edge touch location 808 are appropriately established such that the tactile feedback at the edge location 808 results in the same tactile feedback as other locations on the touch-sensitive display, such as the center location 608 and the off-center location 708.

A corner touch location 908 is shown near a corner of the display 118 in FIG. 9. The corner touch location 908 is closer to the actuator 204 in the upper-right position 918 than to the actuators 204 in the other positions 914, 916, 920. When the same level of tactile feedback is provided by each actuator 204, at the edge location 908, the contribution to tactile feedback that is provided by the actuator 204 in the upper-right position 918 is greater than the tactile feedback provided by the actuators 204 in the other positions 914, 916, 920. In order to provide the same tactile feedback for a corner touch location 908 as for other touch locations, the activation levels in the activation signals sent to the actuators are established based on the location of the touch and result in appropriately different activation levels at the various actuators 204.

Optionally, for a corner touch location, one at or near a corner of the display 118, the closest actuator 204 may be the only actuator that provides tactile feedback. For example, the actuator 204 in the upper-right position 918 provides tactile feedback, but that the actuators 204 in the other positions 914, 916, 920 do not provide tactile feedback. The activation level in the activation signal to the actuator 204 in the upper-right-side position 918 for the corner touch location 908 is appropriately established such that the tactile feedback at the corner location 908 results in the same tactile feedback as other locations on the touch-sensitive display, such as the center location 608, the off-center location 708, or the edge location 808.

Although the examples described above illustrate sending different activation signals to each different actuator, a single signal may alternatively be sent to each actuator to achieve the same consistency of tactile feedback across the display regardless of the location or force of a touch. The consistency of tactile feedback may be achieved in the same way as described above by adjusting a single activation signal that is sent to all actuators, wherein an activation level of the activation signal is based on a location or force of a touch.

Devices incorporating the teachings of the disclosure advantageously provide for consistent tactile feedback across the entire display of the device. For example, when the same type and amount of feedback is to be provided to a center and to a corner of the display, the device incorporating the teachings of the disclosure may adjust the amount of tactile feedback provided by each of the actuators of the device. In so doing, the actual tactile feedback provided to the center may be the same as the actual tactile feedback provided to the corner even though the actuators of the device are at different distances from the center and the corner. The teachings of the disclosure may also provide consistency of tactile feedback that compensates for mechanical implementation constraints or other mechanical properties of the device, such as stiffness or friction between components of the portable electronic device.

A method for providing tactile feedback comprises detecting a touch on a touch-sensitive display and providing tactile feedback by one or more actuators in response to the touch. Tactile feedback is substantially the same regardless of a location of the touch.

A method for providing tactile feedback may have a force of a touch be sufficient to activate tactile feedback. Tactile feedback may substantially be the same regardless of a force of the touch. A method for providing tactile feedback may determine location characteristics of the touch that are used to provide tactile feedback, with the location characteristics comprising horizontal location information, vertical location information, and size information. A method for providing tactile feedback may analyze the location characteristics by using one of a map or table to determine tactile feedback. A method for providing tactile feedback may determine force characteristics of the touch from one or more force sensors and analyze the force characteristics relative to one or more thresholds to determine tactile feedback. A method for providing tactile feedback may determine tactile feedback based on at least one of: a tactile feedback setting, a type of tactile feedback, an amount of tactile feedback. A computer-readable medium may store instructions causing at least one processor to perform the method of providing tactile feedback.

A method for providing tactile feedback comprises receiving one or more touch signals indicating a touch on a touch-sensitive display and sending an activation signal to one or more actuators to provide tactile feedback to the touch-sensitive display. The activation signal is based at least in part on a location of the touch.

A method for providing tactile feedback may have the activation signal comprise an activation level that indicates the amount of tactile feedback. The activation signal may comprise at least one of a pulse, a buzz, a periodic pulse, or a periodic buzz. Tactile feedback may be substantially the same regardless of the location of the touch. The activation signal may be based at least in part on a location of the touch relative to a position of the one or more actuators. The touch signal may indicate the location of the touch. The touch signal may indicate a force of the touch. The activation signal may be based at least in part on the force and at least one position of the one or more actuators. A computer-readable medium may store instructions causing at least one processor to perform the method of providing tactile feedback.

An apparatus comprising one or more actuators arranged and constructed to provide tactile feedback via a touch-sensitive display. At least one processor is configured to receive one or more touch signals comprising information indicative of a location of a touch. The processor may also send one or more activation signals to the one or more actuators to provide tactile feedback. Tactile feedback may be the same regardless of the location of the touch.

An apparatus for providing tactile feedback may have the activation signal be based at least in part on the location relative to a position of at least one of the one or more actuators. The apparatus may comprise a touch sensor operable to provide the touch data. The processor may be further configured to send the one or more activation signals when the one or more touch signals indicate that the touch is imparted with a predetermined force. The apparatus may further comprise one or more force sensors arranged and constructed to provide force data indicative of a force of the touch. The activation level may be further based at least in part on the force of the touch relative to a position of one or more of the one or more actuators. The one or more actuators may be piezoelectric. The apparatus may be at least one of a handheld portable device or a smart phone. Tactile feedback may be substantially the same regardless of one or more mechanical properties of components of the apparatus..

The present disclosure may be embodied in other specific forms without departing from its spirit or essential characteristics. The described embodiments are to be considered in all respects only as illustrative and not restrictive. The scope of the present disclosure is, therefore, indicated by the appended claims rather than by the foregoing description. All changes that come within the meaning and range of equivalency of the claims are to be embraced within their scope.

## Claims

1. A method comprising:
detecting a touch on a touch-sensitive display; and
providing tactile feedback by one or more actuators in response to the touch, wherein tactile feedback is substantially the same regardless of a location of the touch.

2. The method of claim 1, wherein a force of the touch is sufficient to activate tactile feedback.

3. The method of claims 1 or 2, wherein tactile feedback is substantially the same regardless of a force of the touch.

4. The method of claims 1, 2, or 3, further comprising:
determining location characteristics of the touch that are used to provide tactile feedback, the location characteristics comprising: horizontal location information, vertical location information, and size information; and
analyzing the location characteristics by using one of a map or table to determine tactile feedback.

5. The method of claims 1, 2, 3, or 4, further comprising:
determining force characteristics of the touch from one or more force sensors; and
analyzing the force characteristics relative to one or more thresholds to determine tactile feedback.

6. The method of claims 1, 2, 3, 4, or 5, further comprising determining tactile feedback based on at least one of: a tactile feedback setting, a type of tactile feedback, an amount of tactile feedback.

7. A computer-readable medium storing instructions causing at least one processor to perform the method of claim 1.

8. The method of claims 1, 2, 3, 4, 5, or 6, further comprising sending an activation signal to one or more actuators to provide tactile feedback to the touch-sensitive display, wherein the activation signal is based at least in part on a location of the touch, and the activation signal comprises an activation level that indicates the amount of tactile feedback.

9. An apparatus comprising:
one or more actuators arranged and constructed to provide tactile feedback via a touch-sensitive display; and
at least one processor configured to:
receive one or more touch signals comprising information indicative of a location of a touch; and
send one or more activation signals to the one or more actuators to provide tactile feedback;
wherein tactile feedback is the same regardless of the location of the touch.

10. The apparatus of claim 9, wherein the activation signal is based at least in part on the location relative to a position of at least one of the one or more actuators.

11. The apparatus of any of claims 9 or 10, further comprising a touch sensor operable to provide the touch data.

12. The apparatus of any of claims 9, 10, or 11, wherein the processor is further configured to send the one or more activation signals when the one or more touch signals indicate that the touch is imparted with a predetermined force.

13. The apparatus of any of claims 9, 10, 11, or 12, further comprising one or more force sensors arranged and constructed to provide force data indicative of a force of the touch, wherein the activation level is further based at least in part on the force of the touch relative to a position of one or more of the one or more actuators.

14. The apparatus of any of claims 9, 10, 11, 12, or 13, wherein the one or more actuators are piezoelectric.

15. The apparatus of any of claims 9, 10, 11, 12, 13, or 14, wherein tactile feedback is substantially the same regardless of one or more mechanical properties of components of the apparatus.

## Amended claims

### Amended claims in accordance with Rule 137(2) EPC.

**1.** A method comprising:
detecting (502) a touch on a touch-sensitive display (118); and
providing (510) tactile feedback by at least one actuator (120, 204, 304, 404) in response to the touch, wherein the tactile feedback is substantially the same regardless of a location of the touch.

**2.** The method of claim 1, wherein tactile feedback at the location of the touch is substantially the same regardless of the location of the touch.

**3.** The method of claims 1 or 2, wherein the tactile feedback is substantially the same regardless of a force of the touch.

**4.** The method of claims 1, 2, or 3, further comprising:
determining (504) location characteristics of the touch that are used to provide the tactile feedback, the location characteristics comprising: horizontal location information, vertical location information, and size information; and
analyzing the location characteristics by using one of a map or table to determine the tactile feedback.

**5.** The method of claims 1, 2, 3, or 4, further comprising:
determining a distance between the location of the touch and at least one of the at least one actuator; and
utilizing at least the distance to determine the tactile feedback.

**6.** The method of claims 1, 2, 3, 4, or 5, further comprising determining the tactile feedback based on at least one of: a tactile feedback setting, a type of tactile feedback, an amount of tactile feedback.

**7.** A computer-readable medium storing instructions causing at least one processor to perform the method of claim 1.

**8.** The method of claims 1, 2, 3, 4, 5, or 6, further comprising sending an activation signal to the at least one actuator to provide the tactile feedback to the touch-sensitive display, wherein the activation signal is based at least in part on a location of the touch, and the activation signal comprises an activation level that indicates the amount of the tactile feedback.

**9.** An apparatus comprising:
at least one actuator (120, 204, 304, 404) arranged and constructed to provide tactile feedback via a touch-sensitive display; and
at least one processor (102) configured to:
receive one or more touch signals comprising information indicative of a location of a touch; and
send one or more activation signals to the at least one actuator to provide the tactile feedback;
wherein the tactile feedback is substantially the same regardless of the location of the touch.

**10.** The apparatus of claim 9, wherein the activation signal is based at least in part on the location relative to a position of at least one of the at least one actuator.

**11.** The apparatus of any of claims 9 or 10, wherein the tactile feedback at any location on the touch-sensitive display is substantially the same regardless of a location of the touch.

**12.** The apparatus of any of claims 9, 10, or 11, wherein the processor is further configured to send the one or more activation signals when the one or more touch signals indicate that the touch is imparted with a predetermined force.

**13.** The apparatus of any of claims 9, 10, 11, or 12, further comprising one or more force sensors arranged and constructed to provide force data indicative of a force of the touch, wherein the activation level is further based at least in part on the force of the touch relative to a position of one or more of the at least one actuator.

**14.** The apparatus of any of claims 9, 10, 11, 12, or 13, wherein the at least one actuator is piezoelectric.

**15.** The apparatus of any of claims 9, 10, 11, 12, 13, or 14, wherein the tactile feedback is substantially the same regardless of one or more mechanical properties of components of the apparatus.
